(19) Europäisches Patentamt

European Patent Office

Office européen des brevets

(11) **EP 1 264 191 B1**

(12) **EUROPÄISCHE PATENTSCHRIFT**

(45) Veröffentlichungstag und Bekanntmachung des Hinweises auf die Patenterteilung:
**06.07.2005   Patentblatt 2005/27**

(51) Int Cl.⁷: **G01R 31/12**, G01R 27/26, G01R 15/16, H01B 17/28

(21) Anmeldenummer: **01919188.1**

(86) Internationale Anmeldenummer:
**PCT/DE2001/000936**

(22) Anmeldetag: **06.03.2001**

(87) Internationale Veröffentlichungsnummer:
**WO 2001/069272 (20.09.2001 Gazette 2001/38)**

(54) **VORRICHTUNG UND VERFAHREN ZUR ÜBERWACHUNG EINER KONDENSATORDURCHFÜHRUNG**

DEVICE AND METHOD FOR MONITORING A CAPACITOR BUSHING

DISPOSITIF ET PROCEDE POUR SURVEILLER UNE TRAVERSEE DE CONDENSATEUR

(84) Benannte Vertragsstaaten:
**AT BE CH CY DE DK ES FI FR GB GR IE IT LI LU MC NL PT SE TR**

(30) Priorität: **14.03.2000   DE 10012068
24.07.2000   DE 10037432**

(43) Veröffentlichungstag der Anmeldung:
**11.12.2002   Patentblatt 2002/50**

(73) Patentinhaber: **HSP Hochspannungsgeräte Porz GmbH
51145 Köln (DE)**

(72) Erfinder: **KOCH, Norbert
51147 Köln (DE)**

(74) Vertreter: **Berg, Peter, Dipl.-Ing.
European Patent Attorney,
Siemens AG,
Postfach 22 16 34
80506 München (DE)**

(56) Entgegenhaltungen:
**EP-B- 0 829 015          GB-A- 2 007 048
US-A- 3 710 242          US-A- 4 437 134
US-A- 5 640 154**

**Beschreibung**

Die Erfindung betrifft ein Verfahren zur Überwachung einer mit einer elektrischen Betriebsspannung beaufschlagten Kondensatordurchfuhrung, bei der mit einer elektrisch leitenden Einlage ein Spannungsteiler gebildet ist, wobei mit einem mit der Einlage verbundenen Messabgriff und mit Erdpotential mindestens ein Messwert einer elektrischen Messgroße erfasst und gespeichert wird.

Ein solches Verfahren ist aus der EP 0 829 015 B1 bekannt; es dient zur Erfassung von gefährlichen Änderungen der Durchschlagsfestigkeit der Isolation. Bei dem bekannten Verfahren wird lediglich die zwischen dem Messabgriff und Erdpotential anliegende Teilspannung eines kapazitiven Teilers als elektrische Messgröße erfasst und auf eine Änderung der Teilspannung hin überwacht. Dabei werden offensichtlich mehrere Messwerte, beispielsweise jeweils die Amplitude der Teilspannung an aufeinanderfolgenden Zeitpunkten erfasst und gespeichert. Bei dem bekannten Verfahren wird der zeitliche Abstand zweier aufeinanderfolgender detektierter Änderungen der Teilspannung ermittelt und anhand der Häufigkeit der pro Zeiteinheit auftretenden Anderungen auf den Isolationszustand der Kondensatordurchfuhrung geschlossen. Bei dem bekannten Verfahren muss der Zeitpunkt einer Änderung möglichst genau erfaßt werden. Dies erfordert einen hohen Meßaufwand, da dazu die Meßwerte in zeitlich sehr kurzen Abstanden ermittelt werden mussen. Daruber hinaus wirkt sich eine Abweichung der Betriebsspannung von einem Nennwert auf die Genauigkeit der Auswertung aus, da eine Abweichung der Betriebsspannung von ihrem Nennwert auch eine Abweichung der entsprechenden Teilspannung zur Folge hat. Dies ist insbesondere während einer länger andauernden Änderung der Betriebsspannung von Nachteil.

Aufgabe der Erfindung ist es daher, ein Verfahren der eingangs genannten Art anzugeben, daß durch eine Änderung der Betriebsspannung vergleichsweise geringer beeinflußt ist.

Zur Lösung dieser Aufgabe wird bei einem Verfahren der eingangs genannten Art erfindungsgemäß nach Erfassung des mindestens einen Messwerts die Impedanz zwischen dem Messabgriff und dem Erdpotential verändert und mit dem Messabgriff und dem Erdpotential mindestens ein Signalwert eines sich dann bildenden Messsignals erfasst und gespeichert, wobei der zeitliche Abstand zwischen dem Zeitpunkt der Erfassung des einen Messwerts und dem Zeitpunkt der Erfassung des einen Signalwerts derart bemessen ist, dass mögliche Änderungen der Betriebsspannung zwischen den beiden Zeitpunkten vernachlassigbar sind; anhand des Messwerts und des Signalwerts wird durch Quotientenbildung eine Kenngröße ermittelt, die mit einem vorgegebenen Sollwert verglichen wird, und bei einem Abweichen der Kenngröße von dem vorgegebenen Sollwert ein einen Fehler der Kondensatordurchfuhrung anzeigendes Meldesignal gebildet.

Die durch Quotientenbildung ermittelte Kenngröße ist von der Hohe der Betriebsspannung und auch von Schwankungen der Betriebsspannung nahezu unabhängig. Daher ist es nicht erforderlicn, den genauen Wert der Betriebsspannung zu kennen. Wichtig ist nur, das die Betriebsspannung zu beiden Zeitpunkten -also zum Zeitpunkt der Ermittlung des Messwerts und zum Zeitpunkt der Ermittlung des Signalwerts - nahezu den gleichen Wert hatte. Daher kann vorteilhaft auch bei einer von ihrem Nennwert abweichenden Betriebsspannung die Kenngroße ermittelt und zu einer Beurteilung der Isolation der Kondensatordurchfuhrung herangezogen werden. Als Sollwert kann hier die Kenngröße dienen, die für die noch unbeschadigte oder unbeeinflusste Kondensatordurchfuhrung ermittelt wurde oder es kann auch ein fur diese Kondensatordurchfuhrung abgeschatzte oder berechnete Kenngroße verwendet werden.

Eine weitere Losung der oben angegebenen Aufgabe besteht bei einem Verfahren der eingangs genannten Art darin, dass erfindungsgemaß nach Erfassung des mindestens einen Messwerts die Impedanz zwischen dem Messabgriff und dem Erdpotential verandert wird und mit dem Messabgriff und dem Erdpotential mindestens ein Signalwert eines sich dann bildenden Messsignals erfasst und gespeichert wird, wobei der zeitliche Abstand zwischen dem Zeitpunkt der Erfassung des einen Meßwerts und dem Zeitpunkt der Erfassung des einen Signalwerts derart bemessen ist, dass mögliche Änderungen der Betriebsspannung zwischen den beiden Zeitpunkten vernachlässigbar sind; mit dem Signalwert, dem Messwert, der unveranderten Impedanz und der veranderten Impedanz wird anhand der fur den Messwert und der fur den Signalwert jeweils geltenden Spannungsteilergleichung die Impedanz zwischen der Einlage und dem mit der Betriebsspannung beaufschlagten Leiter der Kondensatordurchführung ermittelt; diese wird mit einem vorgegebenen Sollwert verglichen, und bei einem Abweichen der Impedanz von dem vorgegebenen Sollwert wird ein einen Fehler der Kondensatorcurchfuhrung anzeigendes Meldesignal gebildet.

Die Impedanz zwischen der Einlage und dem mit der Betriebsspannung beaufschlagten Leiter der Kondensatordurchfuhrung ist ebenfalls eine von der Hohe der Betriebsspannung unabhangige Große, anhand der auf den Isolationszustand der Kondensatordurchfuhrung geschlossen werden kann. Als Sollwert dient hierbei die entsprechende Impedanz bei einer noch unbeschadigten oder unveranderten Kondensatordurchfuhrung.

Vorzugsweise wird die Veränderung der Impedanz zwischen dem Messabgriff und dem Erdpotential bei einem moglichst geringen Betrag der Messgroße bzw. des Messsignals durchgefuhrt. Dadurch erfolgte die Veranderung der Impedanz, so dass eine Belastung einer dazu erforderlichen Schalteinrichtung aufgrund eines Messstroms moglichst gering ist.

Bevorzugt wird in einer ersten Halbperiode der Betriebsspannung der Messwert erfasst und in der darauffolgenden zweiten Halbperiode der Betriebsspannung der Signalwert erfasst. Dadurch werden der Messwert und der Signalwert in einem sehr kurzen zeitlichen Abstand erfasst, so dass eine Schwankung der Betriebsspannung die Uberwachung weitestgehend unbeeinflußt läßt.

Bevorzugtermassen werden nacheinander mehrere Kenngroßen ermittelt und ein Mittelwert der Kenngroße gebildet. Der Mittelwert der Kenngroße kann dann zusatzlich zum Vergleich mit dem Sollwert herangezogen werden, wobei der Mittelwert der Kenngroße vorteilhafterweise nahezu gänzlich unabhangig von einer Schwankung der Betriebsspannung ist.

Vorzugsweise wird die zwischen dem Messabgriff und dem Erdpotential liegende Impedanz durch Zuschaltung bzw. Abtrennung einer bekannten Fest-Impedanz verandert. Dies ist eine einfache Moglichkeit der Veranderung der Impedanz zwischen dem Messabgriff und dem Erdpotential.

Die Erfindung betrifft auch eine Vorrichtung zur Uberwachung einer mit einer elektrischen Betriebsspannung beaufschlagten Kondensatordurchfuhrung, bei der mit einer elektrisch leitenden Einlage ein Spannungsteiler gebildet ist, wobei ein mit der Einlage verbundener Messabgriff vorgesehen ist, der mit einer Messeinrichtung zur Erfassung einer elektrischen Messgroße verbunden ist.

Aus der oben schon genannten EP 0 829 015 B1 ist auch eine solche Vorrichtung bekannt. Die bekannte Vorrichtung ist lediglich uber eine Zuleitung mit dem Messabgriff der Kondensatordurchfuhrung verbunden. Als elektrische Messgroße wird die an dem Messabgriff gegen Erdpotential anliegende Teilspannung erfasst.

Aufgabe der Erfindung ist es, eine Vorrichtung der eingangs genannten anzugeben, mit der eine Kondensatordurchfuhrung weitgehend unbeeinflusst durch Schwankungen der Betriebsspannung uberwachbar ist.

Diese Aufgabe wird erfindungsgemaß dadurch gelost, dass die zwischen dem Messabgriff und Erdpotential vorliegende Impedanz eine Impedanzanordnung enthalt, der eine Schalteinrichtung zugeordnet ist.

Vorzugsweise ist eine Steuereinrichtung zur Ansteuerung der Schalteinrichtung vorgesehen. Mit Hilfe der Steuereinrichtung kann die Schalteinrichtung automatisch angesteuert werden, so dass die Impedanz automatisch verandert werden kann.

Weiter bevorzugt weist die Messeinrichtung einen Quotientenbildner auf. Mit dem Quotientenbildner kann vorteilhaft der Quotient aus einem bei unveranderter Impedanz ermitteltem Meßwert und einem bei veranderter Impedanz ermitteltem Signalwert gebildet werden. Dieser Quotient kann dann als Kenngroße fur den Zustand der Kondensatordurchfuhrung herangezogen werden.

Weiter bevorzugt enthalt die Impedanzanordnung einen Kondensator, der einerseits mit Erdpotential verbunden ist und andererseits uber die Schalteinrichtung an den Messabgriff angeschlossen ist. Uber die Schalteinrichtung ist der Kondensator mit dem Messabgriff verbindbar bzw. von diesem trennbar.

Die Impedanzanordnung weist bevorzugt eine weitere Fest-Impedanz auf, die zwischen dem Messabgriff und das Erdpotential geschaltet ist. Die weitere Fest-Impedanz kann so gewahlt sein, das das Teilerverhältnis des Spannungsteilers so beeinflußt ist, dass die Messgroße bzw. das Messsignal in gut messbaren Größenordnungen liegen.

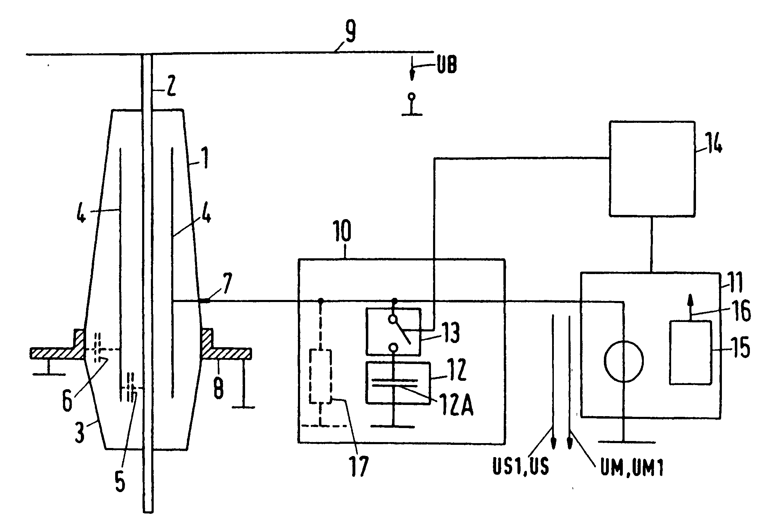

Das Verfahren und die Vorrichtung werden anhand der Zeichnung mit der einzigen Figur erlautert.

In der Figur ist eine Kondensatordurchfuhrung 1 mit einem zentralen Leiter 2, beispielsweise ein Hochspannungsleiter, dargestellt, der von einem Isolationskorper 3 umgeben ist. An dem Isolationskorper 3 ist ein metallischer Flansch 8 zur Halterung der Kondensatordurchfuhrung in einer nicht dargestellten Gehausewand angeordnet. In dem Isolationskorper 3 ist eine leitende Einlage 4 fixiert, die vom elektrischen Leiter 2 elektrisch isoliert ist und diesen umgibt. Die Kondensatordurchfuhrung 1 kann auch mehrere solcher Einlagen aufweisen, der Übersichtlichkeit halber ist jedoch nur diese eine Einlage 4 dargestellt. Diese ist mit einem Messabgriff 7 elektrisch leitend verbunden. Der Leiter 2 ist mit einer Hochspannungsleitung 9 verbunden, an der eine Betriebsspannung UB anliegt. Der Flansch 8 liegt auf Erdpotential.

Der Messabgriff 7 ist uber eine Impedanzanordnung 10 mit einer Messeinrichtung 11 verbunden. Die Impedanzanordnung 10 weist eine Fest-Impedanz 12 auf, die uber eine Schalteinrichtung 13 an den Messabgriff 7 anschließbar und von dem Messabgriff 7 trennbar ist. Die Schalteinrichtung 13 ist mit einer Steuereinrichtung 14 verbunden. Die Schalteinrichtung 13 kann beispielsweise mit einem Halbleiterschalter ausgefuhrt sein. Die Fest-Impedanz 12 ist hier beispielhaft als Kondensator 12A ausgefuhrt. Die Impedanzanordnung 10, die Meßeinrichtung 11 und die Steuereinrichtung 14 bilden eine Vorrichtung 18 zur Uberwachung der Kondensatordurchfuhrung 1.

Mit der leitenden Einlage 4 ist ein Spannungsteiler gebildet. Die eine Impedanz des Spannungsteilers ist durch die zwischen der leitenden Einlage 4 und dem Leiter 2 liegende Impedanz ZH, die im wesentlichen eine Kapazität 5 (gestrichelt dargestellt) aufweist, gebildet. Die andere Impedanz des Spannungsteilers ist durch die zwischen der leitenden Einlage 4 und dem Erdpotential liegende Impedanz ZE gebildet. Diese Impedanz ZE umfasst die innerhalb der Kondensatordurchfuhrung 1 zwischen der Einlage 4 und dem Erdpotential liegende Kapazitat 6 (gestrichelt dargestellt), die dazu parallel liegende Impedanzanordnung 10 und den nicht naher dargestellten Innenwiderstand der Meßeinrichtung 11.

Die Kondensatordurchfuhrung 1 wird mit der Vorrichtung 18 auf einen Fehler uberwacht. Ein Fehler kann eine Veränderung der Kapazitat 5 sein. In der Regel vergroßert sich durch einen solchen Fehler die Kapazitat 5. Eine Zunahme der Kapazitat 5 ist gleichbedeutend mit einer Verringerung der Isolationsfestigkeit zwischen dem Leiter 2 und der Einlage 5.

Zur Uberwachung der Kondensatordurchfuhrung 1 befindet sich die Impedanzanordnung 10 zunachst in einem ersten Messzustand, bei dem die Schalteinrichtung 13 geoffnet und die Fest-Impedanz 12 nicht mit dem Messabgriff verbunden ist. In diesem ersten Messzustand wird zu einem ersten Zeitpunkt $t_1$ ein Meßwert UM1 einer elektrischen Meßgroße UM erfaßt und in einem nicht näher dargestellten Speicher in der Meßeinrichtung 11 gespeichert. Diese Meßgroße UM ist hier die am Messabgriff gegen Erdpotential anliegende elektrische Spannung. In diesem Messzustand der Impedanzanordnung 10 wird die Impedanz ZE durch die Parallelschaltung von der Kapazitat 6 und dem nicht naher dargestellten Innenwiderstand des Messgeräts 11 gebildet. Die Impedanz in diesem Meßzustand wird als unveränderte Impedanz ZE1 bezeichnet.

Nach Erfassung der Meßgroße UM1 wird die Impedanzanordnung 10 in einen zweiten Messzustand versetzt. Dazu wird die Steuereinrichtung 14 durch die Schalteinrichtung 13 gesteuert in den geschlossenen Zustand versetzt. Dadurch ist die Fest-Impedanz 12 jetzt elektrisch leitend mit dem Messabgriff 7 verbunden. Die Impedanz ZE wird nun aus der Parallelschaltung der Kapazitat 6, des nicht naher dargestellten Innenwiderstands der Messeinrichtung 11 und der Fest-Impedanz 12 gebildet. In diesem zweiten Messzustand wird nun zu einem zweiten Zeitpunkt $t_2$ mit der Messeinrichtung 11 ein Signalwert US1 eines sich bildenden Messsignal US erfasst und ebenfalls gespeichert. Das Meßsignal US ist die am Messabgriff gegen Erdpotential anliegende elektrische Spannung. Die Impedanz ZE in diesem zweiten Meßzustand wird als veranderte Impedanz ZE2 bezeichnet.

Der zeitliche Abstand zwischen dem Zeitpunkt $t_1$ und dem Zeitpunkt $t_2$ ist so gewahlt, dass eine eventuell erfolgende Anderung der Betriebsspannung UB zwischen den beiden Zeitpunkten $t_1$ und $t_2$ vernachlassigbar ist. Dies kann beispielsweise so schnell geschehen, dass die Anderung der Betriebsspannung aufgrund ihrer eigenen Periodizitat (mit der Netzfrequenz) vernachlassigbar ist. Dann kann davon ausgegangen werden, dass die Amplitude der Betriebsspannung UB zwischen den beiden Zeitpunkten $t_1$ und $t_2$ konstant geblieben ist.

Fur den Messwert UM1 gilt folgende Spannungsteilergleichung G1:

$$\frac{UM1}{UB} = \frac{ZE1}{ZE1 + ZH} \tag{G1}$$

Fur den Signalwert US1 gilt folgende Spannungsteilergleichung G2:

$$\frac{US1}{UB} = \frac{ZE2}{ZE2 + ZH} \tag{G2}.$$

Da wie oben schon erlautert vorausgesetzt werden kann, dass die Betriebsspannung UB konstant geblieben ist, kann die Betriebsspannung UB durch Gleichsetzen der entsprechend umgeformten Gleichungen G1 und G2 eliminiert werden und es gilt folgende Gleichung G3:

$$UM1 \, \frac{ZE1 + ZH}{ZE1} = US1 \, \frac{ZE2 + ZH}{ZE2} \tag{G3}$$

Wie oben erwahnt, andert sich bei einem Fehler der Kondensatordurchfuhrung 1 lediglich die Impedanz ZH und die Kapazitat 6 bleibt unverandert. Somit sind bis auf die Impedanz ZH samtliche Großen in der Gleichung G3 bekannt, bzw. konstant; aus der Gleichung G3 kann eine Beziehung für eine allein von der Impedanz ZH abhangige Kenngroße K gewonnen werden. Diese Kenngroße K wird mit einem vorgegebenen Sollwert K0 verglichen. Weicht die Kenngroße K von dem vorgegebenen Sollwert K0 ab, so wird ein einen Fehler der Kondensatordurchfuhrung 1 anzeigendes Meldesignal 16 gebildet. Als Sollwert K0 kann eine Kenngroße, die mit dem erfindungsgemaßen Verfahren bei einer unveranderten oder unbeschädigten Kondensatordurchfuhrung ermittelt wurde, verwendet werden; die Kenngroße kann aber auch bei Inbetriebnahme der Kompensatordurchfuhrung 1 ermittelt oder durch Berechnung bestimmt werden.

Als eine Kenngroße K1 kann beispielsweise der Quotient aus dem Messwert UM1 und dem Signalwert US2 gebildet werden. Dazu wird ein in der Messeinrichtung 11 vorgesehener Quotientenbildner 15 herangezogen. Ein Fehler der Kondensatordurchfuhrung 1, also eine Anderung der Kapazitat 5 wirkt sich auf das Teilerverhaltnis des Spannungsteilers und damit auf die Messgroße UM und das Messsignal US aus. Allerdings andern sich die Messgroße UM und das Messsignal US prozentual unterschiedlich. Bei einer Anderung der Betriebsspannung UB hingegen andern sich die Messgroße UM und das Messsignal US prozentual gleich. Durch die prozentual unterschiedliche Anderung der Messgroße UM und des Messsignals US ergibt sich bei veranderter Kapazitat 5 ein gegenuber dem Sollwert K0 anderer Quotient und damit eine davon abweichende Kenngroße K. Die Hohe der Betriebsspannung UB hingegen hat auf den Quotienten und damit auf die Kenngröße K nahezu keine Auswirkung. Insbesondere kann auch die während einer langer andauernden Abweichung der Betriebsspannung UB von ihrem Nennwert ermittelte Kenngröße K zu einem Vergleich mit dem Sollwert K0 herangezogen werden. Die genaue Kenntnis der Betriebsspannung UB ist gerade nicht erforderlich. Sie muss also nicht aufwendig erfasst werden. Eine zeitlich genaue und aufwendige Erfassung des Zeitpunkts einer Änderung ist nicht ebenfalls nicht erforderlich.

Im allgemeinen ist die Kapazität 6 der Kondensatordurchfuhrung 1, der nicht näher dargestellte Innenwiderstand des Meßgerats und der Impedanzbaustein 12 und damit die Impedanzen ZE1 und ZE2 bekannt. Mit den Impedanzen ZE1 und ZE2 sowie dem Meßwert UM1 und dem Signalwert US1 kann mit Hilfe der Gleichung G3 Impedanz ZH, bzw. die Kapazität 6 als Kenngröße KG berechnet werden. Danach ergibt sich die Impedanz ZH gemäß der folgenden Gleichung G4 zu

$$ZH = ZE1 \cdot ZE2 \, \frac{US1 - UM1}{UM1 \cdot ZE2 - US1 \cdot ZE1} \qquad\qquad (G4).$$

Ein besonders einfacher Fall ergibt sich, wenn die Impedanzen ZE1, ZE2 und ZH jeweils als reine Kapazitaten aufgefasst werden konnen. Dann müssen der Messwert UM1 und der Signalwert US1 lediglich ihrem Betrag, nicht aber ihrer Phase nach ermittelt werden. Es ergibt sich dadurch eine besonders einfache Berechnung der Kenngröße K bzw. KC.

Um die Großenordnungen der Meßgröße UM und des Meßsignals US jeweils auf eine zur Messung gut geeignete Großenordnung einzustellen, kann die Impedanzanordnung 10 eine weitere Fest-Impedanz 17 aufweisen (gestrichelt dargestellt). Durch die entsprechende Wahl des Werts der weiteren Fest-Impedanz 17 wird das Teilerverhaltnis des Spannungsteilers entsprechend beeinflusst. Die Fest-Impedanz 17 kann beispielsweise als Kapazitat gewahlt werden. Die Fest-Impedanz 17 muss dann in den obigen Gleichungen in den Impedanzen ZE1 und ZE2 berucksichtigt werden.

Da die Betriebsspannung UB in der Regel periodisch ist, sind auch die Meßgröße UM und das Meßsignal US periodisch. Das Verandern der Impedanz ZE erfolgt dann, wenn die Messgröße UM bzw. das Messsignal US einen geringen Betrag. Dies ist in der Nahe eines Nulldurchgangs der Messgroße UM bzw. des Messsignals als US Der Fall. Dadurch wird die Schalteinrichtung 13 in einem weitgehend unbelasteten Zustand geschaltet. Als Messwert UM1 kann der Maximalwert der Messgroße UM in einer ersten Halbperiode der Betriebsspannung UB und als Signalwert US1 der Maximalwert des Messsignals US in der darauffolgenden zweiten Halbperiode der Betriebsspannung UB erfasst werden. Es konnen auch mehrere Maximalwerte in einem Messzustand erfasst und mit diesen ein gemittelter Maximalwert bestimmt werden, der zur eigentlichen Berechnung der Kenngröße herangezogen wird. Durch die Mittelung konnen Rauscheinflusse verringert werden.

Mit der Messeinrichtung 11 und der Steuereinrichtung 14 konnen auch nacheinander und durch entsprechende Steuerung der Impedanzanordnung 10 mehrere Kenngroßen ermittelt werden. Die Messeinrichtung 11 kann einen nicht naher dargestellten Mittelwertbildner enthalten, mit dem ein Mittelwert MK dieser Kenngroßen gebildet wird. Der Mittelwert MK weist eine sehr geringere Abhangigkeit von Schwankungen der Betriebsspannung UB auf.

Als Meßgroße UM bzw. als Meßsignal US kann auch der sich sich im ersten Messzustand bzw. im zweiten Messzustand ergebende Strom zwischen dem Messabgriff 7 und der Impedanzanordnung 10 herangezogen werden.

## Patentansprüche

1. Verfahren zur Uberwachung einer mit einer elektrischen Betriebsspannung (UB) beaufschlagten Kondensatordurchfuhrung (1), bei der mit einer elektrisch leitenden Einlage (4) ein Spannungsteiler gebildet ist, wobei mit einem mit der Einlage (4) verbundenen Messabgriff (7) und mit Erdpotential mindestens ein Messwert (UM1) einer elektrischen Messgröße (UM) erfasst und gespeichert wird,
   **dadurch gekennzeichnet, dass**

   - nach Erfassung des mindestens einen Messwerts (UM1) die Impedanz (ZE) zwischen dem Messabgriff (7) und dem Erdpotential verändert wird und mit dem Messabgriff (7) und dem Erdpotential mindestens ein Signalwert (US1) eines sich dann bildenden Messsignals (US) erfasst und gespeichert wird, wobei der zeitliche Abstand zwischen dem Zeitpunkt der Erfassung des einen Messwerts (UM1) und dem Zeitpunkt der Erfassung des einen Signalwerts (US1) derart bemessen ist, dass mögliche Anderungen der Betriebsspannung (UB) zwischen den beiden Zeitpunkten vernachlassigbar sind,
   - anhand des Messwerts (UM1) und des Signalwerts (US) durch Quotientenbildung eine Kenngroße (K) ermittelt wird, die mit einem vorgegebenen Sollwert (K0) verglichen wird, und
   - bei einem Abweichen der Kenngroße (K) von dem vorgegebenen Sollwert (K0) ein einen Fehler der Konden-

**EP 1 264 191 B1**

satordurchfuhrung anzeigendes Meldesignal (16) gebildet wird.

2. Verfahren zur Uberwachung einer mit einer elektrischen Betriebsspannung (UB) beaufschlagten Kondensatordurchfuhrung (1), bei der mit einer elektrisch leitenden Einlage (4) ein Spannungsteiler gebildet ist, wobei mit einem mit der Einlage (4) verbundenen Messabgriff (7) und mit Erdpotential mindestens ein Messwert (UM1) einer elektrischen Messgroße (UM) erfasst und gespeichert wird,
   **dadurch gekennzeichnet, dass**

   - nach Erfassung des mindestens einen Messwerts (UM1) die Impedanz (ZE) zwischen dem Messabgriff (7) und dem Erdpotential verandert wird und mit dem Messabgriff (7) und dem Erdpotential mindestens ein Signalwert (US1) eines sich dann bildenden Messsignals (US) erfasst und gespeichert wird, wobei der zeitliche Abstand zwischen dem Zeitpunkt der Erfassung des einen Meßwerts (UM1) und dem Zeitpunkt der Erfassung des einen Signalwerts (US1) derart bemessen ist, dass mögliche Anderungen der Betriebsspannung (UB) zwischen den beiden Zeitpunkten vernachlassigbar sind,
   - mit dem Signalwert (US), dem Messwert (UM1), der unveranderten Impedanz (ZE1) und der veranderten Impedanz (ZE2) anhand der für den Messwert (UM) und der für den Signalwert (US) jeweils geltenden Spannungsteilergleichung (G1,G2) die Impedanz (ZN) zwischen der Einlage (4) und dem mit der Betriebsspannung beaufschlagten Leiter (2) der Kondensatordurchfuhrung (1) ermittelt wird, die mit einem vorgegebenen Sollwert (K0) verglichen wird, und
   - bei einem Abweichen der Impedanz (ZH) von dem vorgegebenen Sollwert (K0) ein einen Fehler der Kondensatordurchfuhrung (1) anzeigendes Meldesignal (16) gebildet wird.

3. Verfahren nach einem der vorhergehenden Anspruche,
   **dadurch gekennzeichnet, dass**
   die Veranderung der Impedanz (ZE) zwischen dem Messabgriff (7) und dem Erdpotential bei einem moglichst geringen Betrag der Meßgroße (UM), bzw. des Messsignals (US1) durchgefuhrt wird.

4. Verfahren nach Anspruch 3,
   **dadurch gekennzeichnet, daß**
   in einer ersten Halbperiode der Betriebsspannung (UB) der Messwert (UM1) erfasst wird und in der darauf folgenden zweiten Halbperiode der Betriebsspannung (UB) der Signalwert (US1) erfasst wird.

5. Verfahren nach einem der vorhergehenden Anspruche,
   **dadurch gekennzeichnet, daß**
   nacheinander mehrere Kenngroßen ermittelt werden und ein Mittelwert (MK) der Kenngroße gebildet wird.

6. Verfahren nach einem der vorhergehenden Anspruche,
   **dadurch gekennzeichnet, daß**
   die zwischen dem Messabgriff (7) und dem Erdpotential liegende Impedanz (ZE) durch Zuschaltung bzw. Abtrennung einer bekannten Fest-Impedanz (12) verandert wird.

7. Vorrichtung zur Überwachung einer mit einer elektrischen Betriebsspannung (UB) beaufschlagten Kondensatordurchfuhrung (1), bei der mit einer elektrisch leitenden Einlage (5) ein Spannungsteiler gebildet ist, wobei ein mit der Einlage (5) verbundener Messabgriff (7) vorgesehen ist, der mit einer Messeinrichtung (11) zur Erfassung einer elektrischen Messgroße (UM) verbunden ist,
   **dadurch gekennzeichnet, daß**
   die zwischen dem Messabgriff (7) und Erdpotential vorliegende Impedanz (ZE) eine Impedanzanordnung (10) enthalt, der eine Schalteinrichtung (13) zugeordnet ist.

8. Vorrichtung nach Anspruch 7,
   **dadurch gekennzeichnet, daß**
   eine Steuereinrichtung (14) zur Ansteuerung der Schalteinrichtung (13) vorgesehen ist.

9. Vorrichtung nach einem der Anspruche 7 bis 8,
   **dadurch gekennzeichnet, daß**
   die Messeinrichtung (11) ein Quotientenbildner (15) aufweist.

10. Vorrichtung nach einem der Anspruche 7 bis 9,

**dadurch gekennzeichnet, daß**

die Impedanzanordnung (10) einen Kondensator (12A) enthalt, der einerseits mit Erdpotential verbunden ist und anderseits uber die Schalteinrichtung (13) an den Messabgriff (7) angeschlossen ist.

**11.** Vorrichtung nach einem der Anspruche 7 bis 10,
**dadurch gekennzeichnet, daß**
die Impedanzanordnung (1) eine weitere Fest-Impedanz (17) aufweist, die zwischen den Messabgriff (7) und das Erdpotential geschaltet ist.

**Claims**

**1.** Method for monitoring a capacitor bushing (1) to which an electrical operating voltage (UB) is applied and in which a voltage divider is formed with an electrically conducting insert (4), at least one measured value (UM1) of an electrical measured quantity (UM) being recorded and stored by using a measuring tap (7), which is connected to the insert (4), and by using earth potential,
**characterized in that**

-   the impedance (ZE) between the measuring tap (7) and the earth potential is changed after recording the at least one measured value (UM1), and at least one signal value (US1) of a measurement signal (US) then forming is recorded and stored using the measuring tap (7) and the earth potential, the temporal interval between the point in time of recording the one measured value (UM1) and the point in time of recording the one signal value (US1) being set such that possible changes in the operating voltage (UB) between the two points in time are negligible,
-   on the basis of the measured value (UM1) and the signal value (US), quotient formation is used to ascertain a characteristic quantity (K), which is compared with a predetermined set value (K0) and,
-   if the characteristic quantity (K) deviates from the predetermined set value (K0), a status signal (16) indicating a fault of the capacitor bushing is formed.

**2.** Method for monitoring a capacitor bushing (1) to which an electrical operating voltage (UB) is applied and in which a voltage divider is formed with an electrically conducting insert (4), at least one measured value (UM1) of an electrical measured quantity (UM) being recorded and stored by using a measuring tap (7), which is connected to the insert (4), and by using earth potential,
**characterized in that**

-   the impedance (ZE) between the measuring tap (7) and the earth potential is changed after recording the at least one measured value (UM1), and at least one signal value (US1) of a measurement signal (US) then forming is recorded and stored using the measuring tap (7) and the earth potential, the temporal interval between the point in time of recording the one measured value (UM1) and the point in time of recording the one signal value (US1) being set such that possible changes in the operating voltage (UB) between the two points in time are negligible,
-   on the basis of the voltage divider equation (G1, G2) respectively applying for the measured value (UM) and for the signal value (US), the signal value (US), the measured value (UM1), the unchanged impedance (ZE1) and the changed impedance (ZE2) are used to ascertain the impedance (ZN) between the insert (4) and the conductor (2) of the capacitor bushing (1) to which the operating voltage is applied, which impedance is compared with a predetermined set value (K0) and,
-   if the impedance (ZH) deviates from the predetermined set value (K0), a status signal (16) indicating a fault of the capacitor bushing (1) is formed.

**3.** Method according to one of the preceding claims, **characterized in that** the changing of the impedance (ZE) between the measuring tap (7) and the earth potential is carried out when the measured quantity (UM), or the measurement signal (US1), is as low as possible.

**4.** Method according to Claim 3, **characterized in that** the measured value (UM1) is recorded in a first half-period of the operating voltage (UB) and the signal value (US1) is recorded in the subsequent second half-period of the operating voltage (UB).

**5.** Method according to one of the preceding claims, **characterized in that** a number of characteristic quantities are ascertained one after the other and an average value (MK) of the characteristic quantity is formed.

6. Method according to one of the preceding claims, **characterized in that** the impedance (ZE) lying between the measuring tap (7) and the earth potential is changed by connecting in or disconnecting a known fixed impedance (12).

7. Device for monitoring a capacitor bushing (1) to which an electrical operating voltage (UB) is applied, in which a voltage divider is formed with an electrically conducting insert (5), a measuring tap (7) connected to the insert (5) being provided and connected to a measuring device (11) for recording an electrical measured quantity (UM), **characterized in that** the impedance (ZE) present between the measuring tap (7) and earth potential contains an impedance arrangement (10) which is assigned a switching device (13).

8. Device according to Claim 7, **characterized in that** a control device (14) is provided for activating the switching device (13).

9. Device according to one of Claims 7 to 8, **characterized in that** the measuring device (11) has a quotient former (15).

10. Device according to one of Claims 7 to 9, **characterized in that** the impedance arrangement (10) contains a capacitor (12A), which on the one hand is connected to earth potential and on the other hand is connected via the switching device (13) to the measuring tap (7).

11. Device according to one of Claims 7 to 10, **characterized in that** the impedance arrangement (1) has a further fixed impedance (17), which is connected between the measuring tap (7) and the earth potential.

**Revendications**

1. Procédé de contrôle d'une traversée (1) de condensateur, à laquelle est appliquée une tension (UB) électrique de fonctionnement et dans laquelle il est formé, avec un insert (4) conducteur de l'électricité, un diviseur de tension, en relevant et en mémorisant au moins une valeur (UM1) de mesure d'une grandeur (UM) électrique de mesure par une prise (7) de mesure reliée à l'insert (4) et par le potentiel de terre,
   **caractérisé en ce que**

   - après avoir relevé la au moins une valeur (UM1) de mesure, on modifie l'impédance (ZE) entre la prise (7) de mesure et le potentiel de terre et l'on relève et on mémorise par la prise (7) de mesure et le potentiel de terre au moins une valeur (US1) de signal d'un signal (US) de mesure se formant alors, le laps de temps compris entre l'instant de la détection d'une valeur (UM1) de mesure et l'instant de la détection d'une valeur (US1) de signal étant mesuré de façon à ce que des variations possibles de la tension (UB) de fonctionnement entre les deux instants soient négligeables,
   - on détermine au moyen de la valeur (UM1) de mesure et de la valeur (US) du signal, par formation d'un quotient, une grandeur (K) caractéristique que l'on compare à une valeur (K0) de consigne prescrite, et
   - si la grandeur (K) caractéristique s'écarte de la valeur (K0) de consigne prescrite, on forme un signal (16) d'avertissement indiquant un défaut de la traversée du condensateur.

2. Procédé de contrôle d'une traversée (1) de condensateur, à laquelle est appliquée une tension (UB) électrique de fonctionnement et dans laquelle il est formé, avec un insert (4) conducteur de l'électricité, un diviseur de tension, en relevant et en mémorisant au moins une valeur (UM1) de mesure d'une grandeur (UM) électrique de mesure par une prise (7) de mesure reliée à l'insert (4) et par le potentiel de terre,
   **caractérisé en ce que**

   - après avoir relevé la au moins une valeur (UM1) de mesure, on modifie l'impédance (ZE) entre la prise (7) de mesure et le potentiel de terre et l'on relève et on mémorise par la prise (7) de mesure et le potentiel de terre au moins une valeur (US1) de signal d'un signal (US) de mesure se formant alors, le laps de temps compris entre l'instant de la détection d'une valeur (UM1) de mesure et l'instant de la détection d'une valeur (US1) de signal étant mesuré de façon à ce que des variations possibles de la tension (UB) de fonctionnement entre les deux instants soient négligeables,
   - on détermine, par la valeur (US) du signal, la valeur (UM1) de mesure, l'impédance (ZE1) inchangée et l'impédance (ZE2) modifiée, au moyen de l'équation (G1, G2) du diviseur de tension valant respectivement pour la valeur (UM) de mesure et pour la valeur (US) du signal, l'impédance (ZN) entre l'insert (4) et le conducteur (2), auquel s'applique la tension de fonctionnement, de la traversée (1) du condensateur, impédance que l'on compare à une valeur (K0) de consigne prescrite, et

- si la grandeur (K) caractéristique s'écarte de la valeur (K0) de consigne prescrite, on forme un signal (16) d'avertissement indiquant un défaut de la traversée du condensateur.

3. Procédé suivant l'une des revendications précédentes, **caractérisé en ce que** l'on effectue la variation de l'impédance (ZE) entre la prise (7) de mesure et le potentiel de terre pour une valeur absolue aussi petite que possible de la grandeur (UM) de mesure ou du signal (US1) de mesure.

4. Procédé suivant la revendication 3, **caractérisé en ce que** l'on relève la valeur (UM1) de mesure dans une première demi-période de la tension (UB) de fonctionnement et on relève la valeur (US1) de signal dans la deuxième demi-période suivante de la tension (UB) de fonctionnement.

5. Procédé suivant l'une des revendications précédentes, **caractérisé en ce qu'**on détermine l'une après l'autre plusieurs grandeurs caractéristiques et on forme une valeur (MK) moyenne des grandeurs caractéristiques.

6. Procédé suivant l'une des revendications précédentes, **caractérisé en ce que** l'on modifie l'impédance (ZE) comprise entre la prise (7) de mesure et le potentiel de terre en branchant ou en séparant une impédance (12) fixe connue.

7. Dispositif de contrôle d'une traversée de condensateur à laquelle est appliquée une tension (UB) électrique de fonctionnement, dans laquelle il est formé avec un insert (5) conducteur de l'électricité un diviseur de tension, une prise (7) de mesure reliée à l'insert (5) et reliée à un dispositif (11) de mesure pour la détection d'une grandeur (UM) électrique de mesure étant prévue,

   **caractérisé en ce que** l'impédance (ZE) comprise entre la prise (7) de mesure et le potentiel de terre comporte un dispositif (10) d'impédance auquel est associé un dispositif (13) de commutation.

8. Dispositif suivant la revendication 7, **caractérisé en ce qu'**il est prévu un dispositif (14) de commande du dispositif (13) de commutation.

9. Dispositif suivant l'une des revendications 7 à 8, **caractérisé en ce que** le dispositif (11) de mesure comporte un formateur (15) de quotient.

10. Dispositif suivant l'une des revendications 7 à 9, **caractérisé en ce que** le dispositif (10) d'impédance comporte un condensateur (12A) qui est relié, d'une part, au potentiel de terre et, d'autre part, par l'intermédiaire du dispositif (13) de commutation à la prise (7) de mesure.

11. Dispositif suivant l'une des revendications 7 à 10, **caractérisé en ce que** le dispositif (1) d'impédance comporte une autre impédance (17) fixe qui est montée entre la prise (7) de mesure et le potentiel de terre

US1,US      UM,UM1

EP 1 264 191 B1